# EUROPEAN PATENT APPLICATION

(11) **EP 1 124 255 A2**
(43) Date of publication of application: **16.08.2001**
(21) Application number: 01101049.3
(22) Date of filing: 16.03.2000
(51) Int. Cl.: H01L 21/66, C23C 16/44, C23C 16/52, G01B 11/06, H01J 37/32

(54) **Etching process in the fabrication of electronic devices**

(30) Priority: 05.04.1999 US 286493
(62) Divisional of application: 00916462.5
(71) Applicant: Applied Materials, Inc., Santa Clara, California 95054 (US)
(72) Inventor: Grimbergen, Michael N., Redwood City, California 94065 (US); Lill, Thorsten B., Sunnyvale, California 94087 (US)
(74) Representative: Bayliss, Geoffrey Cyril

(57) **Abstract**

A chamber 28 comprises a radiation source 58 capable of emitting radiation having a wavelength that is substantially absorbed in a predetermined pathlength in a thickness of a layer 22 on a substrate, and a radiation detector 62 adapted to detect the radiation. The radiation is substantially absorbed in a first thickness of the layer 22, and after at least partial processing of the layer 22, is at least partially transmitted through a second thickness of the layer 22 and reflected by one or more underlayers 24 of the substrate 20.

## Description

The present invention relates to the detection of an endpoint during processing of a substrate.

In the fabrication of devices for electronic applications, semiconductor, dielectric and conductor materials, such as for example, polysilicon, silicon dioxide, and metal containing layers, are deposited on a substrate and etched to form features such as patterns of gates, vias, contact holes and interconnect lines. These features are typically formed by chemical vapor deposition (CVD), physical vapor deposition (PVD), oxidation and etching processes. For example, in a typical etching process, a patterned mask of photoresist or oxide hard mask is formed on a deposited layer by photolithographic methods and exposed portions of the deposited layer are etched by an energized halogen gas, such as Cl₂, HBr and BCl₃. In a typical CVD process, a gas provided in the chamber is decomposed to deposit a layer on the substrate. In PVD processes, a target facing the substrate is sputtered to deposit the target material onto the substrate.

One problem with conventional deposition and etching processes is that it is difficult for the operator to determine when to end the process. For example, in deposition processes, it is sometimes desirable to change process conditions to change the nature of the film being deposited on the substrate or to stop deposition after a desired film thickness has been obtained. In etching processes, it is often desirable to stop etching of a particular layer without etching through or otherwise damaging one or more underlayers, especially when the underlayer is thin, such as for example, a gate oxide underlayer below a polysilicon or silicon layer. It is also desirable to stop the etching process on the layer because the underlayer is easily damaged by impingement of energetic plasma species.

Endpoint detection methods are used to determine completion of a stage of the etching or deposition process. In one method, a change in the emission spectra of a plasma is analyzed to determine a compositional change in a layer being deposited or etched, for example, one that occurs after a layer is etched through and an underlayer having a different chemical composition is exposed, as for example, taught in U.S. Patent No. 4,328,068, which is incorporated herein by reference. However, conventional plasma emission methods detect a process endpoint only after the layer has been etched through and the underlayer exposed, and exposure to the plasma can damage the underlayer. Also, changes in the intensity of the plasma and absorption of selected wavelengths of the plasma emission by the chamber window reduces detection accuracy.

In another endpoint measurement method, known as interferometry, a light beam directed onto a layer on a substrate is partially reflected from the surface of the layer, and partially transmitted through the layer and reflected by one or more underlayers, substantially throughout the process being conducted on the substrate. Constructive and destructive interference of the multiple reflections give rise to an interference pattern which undergoes periodic maxima and minima depending upon the path length of the radiation through the thickness of the layer being processed on the substrate. Before processing of the substrate, an initial thickness of the layer is assumed or measured. During processing, the observed periodic maxima and minima of a measured interference pattern is directly correlated to a calculated reduction in thickness of the layer (which would result in a changing pathlength of the radiation transmitted through the layer being processed) to estimate an endpoint of the process. However, this process requires an accurate knowledge of the initial thickness and refractive index of the layer being etched, which are often difficult to obtain and which can change across the surface of a substrate or from one substrate to another. Inaccurate measurements of either the initial thickness or refractive index of the layer throws off the entire detection method because the calculation of the residual thickness of the layer (from the periodic maxima and minima of the detected interference fringes) will lead to an erroneous estimate of the final thickness of the layer. In addition, variations in the thickness and refractive index of the layer that normally occur in manufacturing will require accurate measurement of these parameters for each and every substrate that is etched or deposited upon, which is an impractical solution. Thus, this method has limited utility, especially for measuring residual thickness of polysilicon layers that are superimposed on thin gate oxide layers, because the margin of error is very small due to the thinness of the underlying gate oxide layer.

In yet another endpoint detection method, known as ellipsometry, a polarized light beam that is at least partially reflected from a layer being processed on a substrate is analyzed to determine changes in the phase and magnitude of the reflected light beam that occur as the layer is being processed, as for example disclosed in U.S. Patent Nos. 3,874,797 and 3,824,017, both of which are incorporated herein by reference. However, it is difficult to obtain accurate measurements of the thickness of a layer on the substrate without using a polarized light beam having multiple wavelengths, as for example, described in *Multiwavelength Ellipsometry for Real-Time Process Control of the Plasma Etching of Patterned Samples,* Maynard Layadi and Tseng-Chung Li, J. Vac. Sci. Technol. B. 15(1), January/February 1997. The multiple wavelengths and complex phase and magnitude measurements are difficult to make. In addition, deposits formed on the window of the chamber change the polarization of the light beam passing through the window which can result in erroneous ellipsometric measurements.

Thus, it is desirable to have an endpoint detection method that detects a change in a stage of a process being conducted on a substrate immediately before or after processing of the layer is completed and without damaging underlayers. It is further desirable to have an endpoint detection apparatus that provides a detection signal prior to etching through or deposition of a layer to allow the etching or deposition process to be changed at a suitable time. It is also desirable to have an endpoint measurement system which measures remaining thickness or a change in thickness of a layer being processed, with high resolution, low signal to noise ratio and independent of the strength of the radiation transmitted through the chamber.

Embodiments of the present invention satisfy the above identified needs, in principle, by detecting an endpoint during processing of a substrate with accuracy and repeatability. In one embodiment, the present invention comprises a chamber for processing a substrate, the chamber comprising a radiation source capable of emitting radiation having a wavelength that is substantially absorbed in a predetermined pathlength in a thickness of the layer and a radiation detector adapted to detect the radiation. In another embodiment, the chamber further comprises a filter in a path of the radiation, the filter adapted to selectively pass through the radiation.

In another aspect, the present invention relates to a method of processing a substrate, in which, the substrate is placed in a process zone, and process conditions are maintained in the process zone for processing a layer on the substrate, the process conditions including, without limitation, one or more of gas composition, gas flow rate, an operating power level of a gas energizer, gas pressure and temperature. Radiation having a wavelength that is absorbed in a predetermined pathlength of a thickness of the layer being processed on the substrate is provided. A change in the radiation is detected after processing of a predetermined thickness of the layer.

The method is particularly useful for etching a layer on a substrate, in which, the substrate is placed in a process zone which is maintained at process conditions suitable for etching the layer. Radiation is provided on the substrate, the radiation having a wavelength that is substantially absorbed in a predetermined pathlength in a thickness of the layer being etched on the substrate. A change in the radiation is detected.

In yet another aspect, the present invention relates to a method of selecting a wavelength for determining an endpoint of a process being performed on a substrate, the method comprising the step of determining a wavelength of a radiation characterized in that when the radiation having the wavelength is incident on the substrate and upon approaching the endpoint of the process, there occurs a detectable change in intensity of the reflected radiation that arises from a transition between substantial absorption of the radiation by the layer being processed on the substrate to at least partially reflection by one or more underlayers on the substrate.

In yet another aspect, the present invention comprises a method of etching a layer on a substrate in a chamber, the method comprising the steps of placing the substrate in the chamber; providing in the chamber, a process gas comprising etchant gas and cleaning gas, and maintaining process conditions to etch the layer on the substrate and simultaneously clean a surface of the chamber; and prior to etching through the layer, changing the composition of the process gas to remove the cleaning gas.

In yet another aspect, the present invention relates to an apparatus for detecting an endpoint of a process being performed on a layer on a substrate. The apparatus comprises a radiation source capable of emitting a radiation having a wavelength that is substantially absorbed in a predetermined pathlength in a thickness of a layer on the substrate, and a radiation detector adapted to detect the radiation and generate a signal. The apparatus further includes a memory comprising a computer-readable medium having a computer-readable program embodied therein, the computer readable program including a set of instructions to detect a change in the signal to determine the endpoint of the process.

In yet another aspect, the present invention relates to a substrate processing apparatus comprising a chamber having a support adapted to support a substrate in the chamber, a gas delivery system adapted to introduce gas into the chamber, a plasma generator adapted to energize the gas in the chamber, an exhaust comprising a throttle valve adapted to control the pressure of gas in the chamber, and a controller adapted to control one or more of the gas delivery system, plasma generator, or throttle valve, to change a process condition in the chamber in relation to an endpoint signal. The apparatus further includes an endpoint detection system comprising a radiation source capable of emitting radiation having a wavelength that is substantially absorbed in a predetermined pathlength in a thickness of the layer, and a radiation detector adapted to detect the radiation and generate a signal. A memory is coupled to the controller of the chamber, the memory comprising a computer-readable medium having a computer-readable program embodied therein for directing operation of the substrate processing apparatus. The computer readable program includes a set of instructions to detect a change in the signal to determine an endpoint of the process and provide an endpoint signal to the controller.

These and other features, aspects, and advantages of the present invention will be better understood from the following drawings, description and appended claims, which illustrate examples of the invention. While the description and drawings below illustrate exemplary features of the invention, it is to be understood that each of the features can be used in the invention in general, not merely in the context of the particular drawing, and the invention includes any combination of these features.
Figure 1a is a schematic sectional view of a substrate having a layer that at least partially absorbs radiation having a predetermined wavelength and partially reflects the radiation;
Figure 1b is another view of the substrate of Figure 1a, after a portion of the layer on the substrate is etched showing continued absorption of the radiation in the layer;
Figure 1c is another view of the Figure 1 b, after partial completion of etching of the layer on the substrate when the radiation is at least partially transmitted through the etched layer and at least partially reflected from one or more underlayers;
Figure 2 is a schematic sectional side view of a chamber and endpoint detection system according to the present invention;
Figure 3 is a flowchart of a process for selecting a suitable radiation having the desired wavelength;
Figure 4 is a graph of the intensity peaks of different wavelengths of radiation originating from an emission spectra of a Hg lamp and at least partially reflected from a layer on a substrate;
Figure 5 is a graph of traces of the intensity of radiation having different wavelengths, originating from an emission spectra of a Hg lamp, that are at least partially reflected from a layer being etched on a substrate, showing the traces at particular wavelengths change as the thickness of the layer is reduced during etching;
Figure 6a and 6b are graphs showing traces of the intensity of radiation having a preselected wavelength that is absorbed in a layer being processed on the substrate, and during processing is least partially reflected from an underlayer on the substrate;
Figure 7 is a graph showing a portion of a trace of radiation that is at least partially reflected from the substrate during processing of the substrate and analyzed using a series of boxes around the end of the trace to determine the process endpoint, each box having a preset signal height and time length;
Figure 8 is a graph showing a trace of the reflected intensity of radiation as analyzed in a series of boxes having a two-column criteria comprising windows exiting upward and downward;
Figure 9 is a flowchart of a process for processing a layer on a substrate and changing process conditions upon detecting an endpoint of the process;
Figure 10 is an illustrative block diagram of the hierarchical control structure of a process control software of a computer-readable program;
Figure 11 is a graph of a mathematically modeled trace of the reflected intensity of radiation from a layer on the substrate for increasing thickness of the layer that occurs during a deposition process, such as CVD or PVD;
Figure 12a is a graph showing a calculated trace of the intensity of radiation reflected from a substrate comprising a small grained polysilicon layer over a silicon dioxide layer on silicon, for increasing wavelengths of the radiation;
Figure 12b is a graph of a trace of the experimentally determined values of n and k of the complex refractive index for the polysilicon layer on the substrate of Figure 12a, for increasing wavelengths of the radiation;
Figure 13 is a graph showing a calculated trace of the intensity of radiation having a preselected wavelength that is at least partially reflected from a substrate comprising a polysilicon layer and different thicknesses of an underlying silicon dioxide layer on silicon;
Figure 14a is a graph showing a calculated trace of the intensity of radiation having a preselected wavelength of 2537 angstroms that is at least partially reflected from a substrate comprising an aluminum layer over a silicon dioxide layer on silicon; and
Figure 14b is a graph showing a calculated trace of the intensity of radiation having a preselected wavelength of 3650 angstroms that is at least partially reflected from the substrate of Figure 14a.

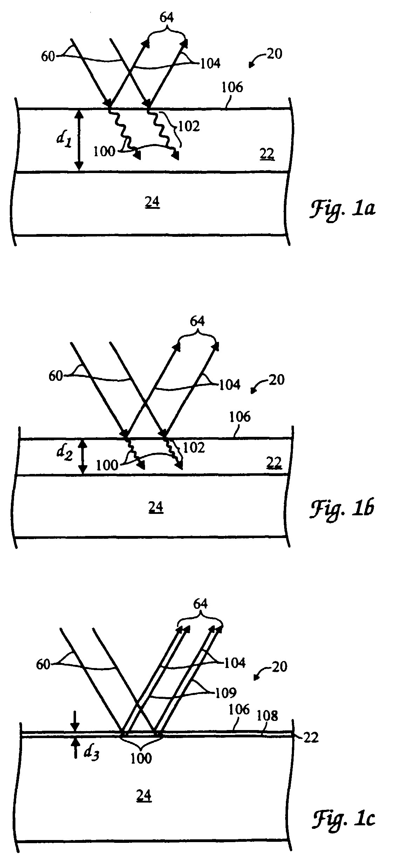

The present invention is useful for detecting completion of a process stage or an endpoint of a process, such as a deposition process or an etching process, which is used to deposit or etch features from semiconductor, dielectric, or metallic conductor materials on a substrate **20**. By substrate **20** it is meant an underlying support, such as a wafer of silicon, compound semiconductor, or dielectric, having thereon a plurality of layers **22, 24**, such as for example, the structure illustrated in Figure 1a. When etching the layers **22** on the substrate **20** in a typical etching process, it is desirable to stop etching upon reaching or before reaching the underlayer **24**, as illustrated in Figures 1a through 1c. Alternatively, when depositing a layer **22** on the substrate **20** it is desirable to stop deposition upon reaching the desired thickness of the layer **22**. The present invention is also useful for detecting completion of stages in chemical vapor deposition (CVD) and physical vapor deposition (PVD) processes, for example, when depositing a layer having a fixed thickness or when changing from deposition of a secondary or nucleation layer to deposition of a primary or growth layer. While examples are provided to illustrate the principles of the invention, the present invention should not be limited to the examples provided herein, and includes all applications that would be apparent to one of ordinary skill in the art.

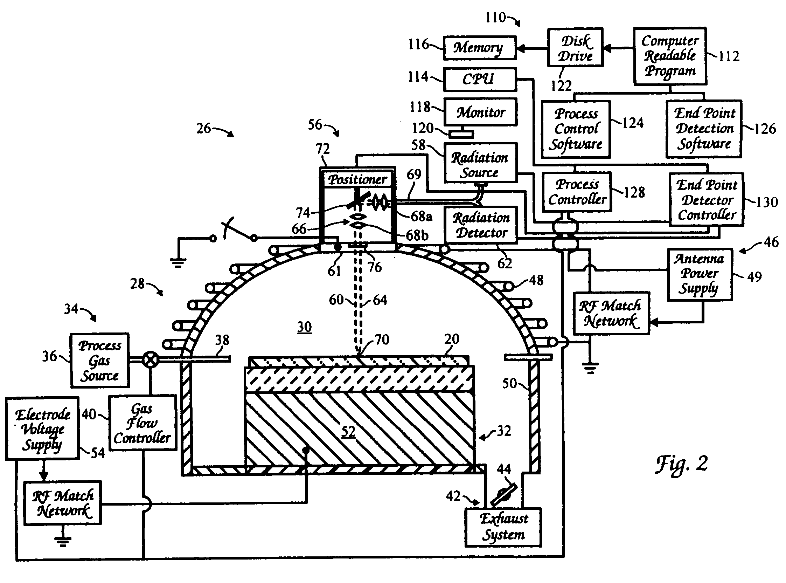

In an illustrative etching process, the substrate **20** is etched in an apparatus **26** schematically shown in Figure 2. The apparatus **26** comprises a chamber **28** having a process zone **30** for processing the substrate **20** and a support **32** that supports the substrate **20** in the process zone **30**. Process gas is introduced into the chamber **28** through a gas delivery system **34** comprising a process gas supply **36**, gas outlets **38** located around the periphery of the substrate **20** (as shown) or in a showerhead mounted on the ceiling of the chamber (not shown), and a gas flow controller **40** for controlling the flow rate of the process gas. Spent process gas and etchant byproducts are exhausted from the chamber **28** through an exhaust **42** comprising roughing and turbomolecular pumps (not shown) and a throttle valve **44** to control the pressure of process gas in the chamber **28.**

An energized gas or plasma is generated from the process gas by a plasma generator **46** that couples RF or microwave energy to the process gas in the process zone **30** of the chamber **28,** such as for example, an inductor antenna **48** comprising one or more coils powered by an antenna power supply **49** that inductively couple RF energy to the chamber. In addition, a first process electrode **50** such as an electrically grounded ceiling or sidewall of the chamber **28** and a second electrode **52** such as an RF biased support **32** below the substrate **20**, can be used to further energize the gas in the chamber **28**. The first and second electrodes **50**, **52** are electrically biased relative to one another by an RF voltage provided by an electrode voltage supply **54**. The frequency of the RF voltage applied to the inductor antenna **48** and the electrodes **50**, **52** is typically from about 50 KHz to about 60 MHz and more typically about 13.56 MHz.

The chamber **28** further comprises an endpoint detection system **56** to detect an endpoint of a stage of the process being performed on the substrate **20**. The endpoint detection system **56** comprises a radiation source **58** for emitting radiation from outside or inside the chamber **28**. When the radiation source **58** is outside the chamber **28**, the radiation **60** passes through a window **61** in the chamber to be incident on the substrate **20**. The radiation source **58** provides radiation such as for example, ultraviolet, infrared or x-ray radiation. The radiation source **58** can provide radiation having only a predominant wavelength, such as a monochromatic light having primarily radiation at a single or a few wavelengths, for example, a He-Ne or Nd-YAG laser. Alternatively, the radiation source **58** can provide multiple wavelengths of radiation, such as polychromatic light, which are filtered to selectively pass through substantially only a single wavelength. Suitable radiation sources **58** for providing polychromatic light include Hg discharge lamps that generate a polychromatic spectrum of light having wavelengths in the range of from about 200 to about 600 nanometers, arc lamps such as xenon or Hg-Xe lamps and tungstenhalogen lamps; and light emitting diodes (LED). The radiation source **58** can also comprise an emission from a plasma generated inside the chamber **28**, the plasma emission being generally multispectral, i.e., providing radiation having multiple wavelengths across an entire spectrum.

In certain processes, it is preferred to have a radiation source **58** that provides nonpolarized radiation, such as for example, unpolarized light. One reason is that variations in the intensity of polarized radiation reflected from the substrate **20** can be masked by changing absorption characteristics of the energized gas or plasma. In addition, the state of polarization of the radiation also influences its absorption in materials having oriented crystalline structures, such as crystals having other than cubic symmetry. Also, the polarization state of the radiation can change when it passes through a thin residue film that deposits on the window **61** of the chamber **28** during the process, and the polarization state also changes as the thickness of the residue film increases, which gives rise to erroneous measurements. Thus, for certain processes, depending on the process gas composition and the location of the source of radiation, it may be preferred to use a radiation source **58** providing unpolarized radiation. A normal incidence of the radiation onto the substrate **20** can reduce such effects. Normal incidence also provides a more accurate endpoint reading for a substrate **20** having tall and narrowly spaced features, such as resist features, over the layers **22, 24**, because the normally incident radiation is not blocked from reaching the layers **22, 24** by the height of the resist features. However, it should be understood that normal incidence is not necessary for detection of the reflected radiation and that other angles of incidence may be employed.

The endpoint detection system **56** further comprises a radiation detector **62** for detecting radiation **64** reflected by the substrate **20**. The radiation detector **62** comprises a radiation sensor, such as a photovoltaic cell, photodiode, photomultiplier, or phototransistor, which provides an electrical output signal in response to a measured intensity of radiation **64**. The signal can comprise a change in the level of a current passing through an electrical component or a change in a voltage applied across an electrical component. A suitable system for coupling the radiation detector **62** to the chamber **28** comprises a fiberoptic cable **69** leading from the chamber **28** to the sensor of the radiation detector **62**.

Optionally, a lens assembly **66** is used to focus radiation emitted by the radiation source **58** onto the substrate **20** and/or to focus radiation **64** at least partially reflected back from the layers **22, 24** on the substrate **20** onto the sensor of the radiation detector **62**. For example, for a radiation source **58** comprising a Hg-discharge lamp located outside the chamber **28,** as shown in Figure 2, a plurality of convex lenses **68a, 68b** can be used to focus radiation from the lamp through the window **61** and onto a beam spot **70** on the substrate **20**. The area of the beam spot **70** should be sufficiently large to provide an accurate measurement of the surface topography of the substrate **20**. The lenses **68a**, **68b** can also be used to focus reflected radiation **64** back onto the sensor of the radiation detector **62**.

Optionally, a positioner **72** is used to scan the incident radiation **60** across the substrate surface to locate a suitable portion of the substrate **20** on which to "park" the beam spot **70**. The positioner **72** comprises one or more primary mirrors **74** that rotate at small angles to deflect radiation from the radiation source **58** onto different positions of the substrate surface (as shown). Alternatively, the mirrors **74** can also direct radiation emitted from a plasma emission and at least partially flected off the layers **22**, **24** on the substrate **20** back onto the radiation detector **62**. Additional secondary mirrors (not shown) can be used to intercept and focus reflected radiation back on the radiation detector **62**. The positioner **72** can also be used to scan the radiation in a raster pattern across the substrate **20**. In this version, the positioner **72** further comprises a movable stage (not shown) upon which the radiation source **58**, lens assembly **66**, and radiation detector **62** are mounted. The movable stage can be moved through set intervals by a drive mechanism, such as a stepper motor, that scans or otherwise moves the beam spot **70** across the substrate **20**.

Radiation having a plurality of wavelengths, such as polychromatic light from a lamp or a plasma emission spectra, can be suitable filtered by placing a filter **76** in the path of the incident or reflected radiation **60, 64**. The filter **76** is typically located in the lens assembly **66** but can also be located at other positions in the chamber **28**, for example, in the chamber window **61**, in front of the radiation detector **62**, or in front of the radiation source **58**. A suitable filter **76** comprises a stack of thin films on a transparent support that selectively transmits radiation having the desired wavelength or a lens made from a material that selectively passes radiation having the desired wavelength. The filter **76** can also comprise a diffraction grating having a diffraction spacing that scatters radiation having undesirable wavelengths and allow radiation having the desired wavelength to pass through. Other suitable or equivalent filtering means, for example, attenuation of radiation through a long pathlength in a partially absorbing material, or selective electronic filtering of the signal from the radiation detector **62** to read only the portion of the signal corresponding to radiation having the desired wavelength, can also be used.

In the present method, radiation having a wavelength that is substantially absorbed in a predetermined pathlength within a thickness of the layer **22** being processed on the substrate **20**, is selected for endpoint detection. The principles of the present invention can be explained as follows. Generally, when an optically absorbing layer **22** (medium 1) lies on an underlayer **24** (medium 2), its absorption/reflectivity can be approximately described by a summation equation. The radiation in the process environment (medium zero) in the chamber **28** that is incident on the layer **22** (medium 1) has a first surface reflection determined by the complex Fresnel coefficient r₁ = (n₀-n₁)/(n₀+n₁) where n₀ and n₁ are the complex refractive indices of media 0 and 1. The complex refractive index **n** is defined as **n = n - ik** where **n** and **k** are the real and imaginary parts, being the refractive index and extinction coefficient, respectively. Radiation not reflected by the layer **22** is transmitted into the layer **22** according to the complex Fresnel transmission coefficient **t**₁ = 2**n**₀/(**n**₀+**n**₁). Transmitted radiation is then absorbed in the layer **22** (medium 1) as a function of its depth *d* by the factor exp(-4Πk₁d/λ) where λ is the wavelength of the incident radiation. If the incident radiation has not been fully absorbed before reaching the rear of the layer **22** some of the radiation is reflected back according to the equation, **r**₂ = (**n**₁-**n**₂)/(**n**₁ + **n**₂), where **n**₂ is the complex refractive index for layer **22** (medium 2). The part of the reflection which remains after absorption during the round trip is transmitted back into medium (0), where it combines with the original reflection, but with a phase change δ = 2 Π n₁ d₁/λ which depends upon the round trip distance covered. The net reflected amplitude is approximately, **r**ₙₑₜ ≅ **r**₁ + **t**₁ **t**₁' **r**₂ exp(+2iδ) exp (-4Πk₁d/λ), where multiple reflections have been neglected. Explicit formulations may be found in references such as M. Born and E. Wolf, Principles of Optics, Pergamon Press (1965), which is incorporated herein by reference. When *d* and *k*_{*1*} are large enough, absorption dominates and the second term is zero, producing a constant net reflection as a function of thickness *d.* Once *d* becomes sufficiently small, however, absorption no longer dominates and the net reflection is no longer constant as *d* is varied. This variation comes from the changing phase and magnitude of the second term as *d* is changed. Depending on the magnitude of *k*_{*1*}*,* the variation in total reflected intensity with *d*_{*1*} can appear periodic, with an increasing amplitude as *d*_{*1*} tends to zero, or simply have a characteristic feature or signature, such as for highly absorbing metal layers **22**.

These complex attributes of the reflected and absorbed radiation and their dependency upon the changing thickness of the layer **22** can be illustrated by the simplified representations of Figures 1a through 1c. Referring to Figure 1a, initially, a component **100** of the radiation **60** that is incident on the layer **22** is substantially absorbed in a predetermined pathlength **102** in a thickness *d*_{*1*} of the layer **22** and a component **104** is reflected from a surface **106** of the layer **22**. The pathlength **102** necessary for substantial absorption of the component **100** depends upon the wavelength λ of the radiation **60**, the incident angle, and the extinction coefficient *k* of the material making up the layer **22**, as described above. For example, the component **100** can be substantially absorbed while traveling through a distance of a pathlength **102** that is less than the thickness *d*_{*1*} of the layer **22**, as illustrated schematically in Figure 1a. The pathlength **102** in which the component **100** of the radiation is substantially absorbed can also be larger than the thickness *d*_{*1*} of the layer **22**, for example, the component **100** can travel through the thickness *d*_{*1*} of the layer **22**, be reflected back by the interface **108**, and thereafter be absorbed while traveling a second time through the thickness *d*_{*1*} of the layer **22**. As another example, the component **100** could also be reflected back by the interface **108**, travel through the thickness *d*_{*1*} of the layer **22** a second time, and subsequently be reflected back into the layer **22** by the surface **106**, and so on via means of multiple internal reflections.

During processing, the thickness of the layer **22** changes and becomes thinner as it is etched in the etching process. However, the radiation component **100** is continued to be absorbed even in the thinner layer **22** having the smaller thickness of *d*_{*2*}, as illustrated in Figure 1b. While not essential for operation of the present method, continued absorption of the component **100** into the thinner and partially etched layer **22** during processing reduces the possibility of erroneous signal interpretation or endpoint detection. Also, interpretation of the intensity of the summed reflected radiation **64** that is detected by the radiation detector **62** is less complex and is easier to perform when there is a significant change in signal intensity over a relatively short time period toward the end of a particular process stage. While the component **100** is illustrated as being substantially absorbed while traveling through a distance of a pathlength **102** that is less than the thickness *d*_{*2*} of the layer **22**, the pathlength **102** of substantially absorption can also be larger than the thickness *d*_{*2*} of the layer **22**, as discussed before.

Now referring to Figure 1c, toward the end of the process being performed on the substrate **20**, the component **100** of the radiation **60** is now transmitted through the remaining thickness *d*_{*3*} of the etched layer **22** on the substrate **20**, which is now much smaller than the predetermined absorption pathlength **102**, and is at least partially reflected by the interface **108** between the layer **22** and the underlayer **24** to provide a secondary component **109** of reflected radiation. While numerous other reflections and refractions occur across the layer **22** at this stage, in a simplified representation, the secondary component **109** (which is reflected from the interface **108** of the layers **22, 24**) constructively or destructively interferes with the primary component **104** (which is reflected from the top surface **106** of layer **22**) to provide a summed intensity of reflected radiation **64** which is detectable by the radiation detector **62**. In addition, if the layer **24** is transparent (gate oxide layers can be transparent) additional components will reflect from other interfaces that lie below the interface **108** (not shown in Figure 1c).

### Empirically Determined Absorption Trace for Endpoint Detection

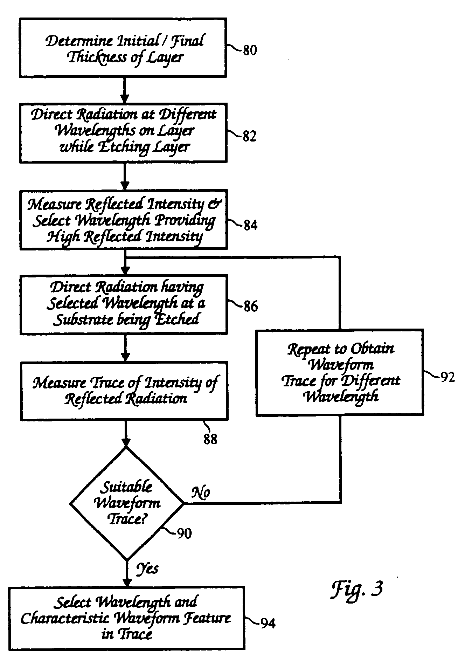

Radiation having a suitable wavelength **64** for use in the endpoint detection process can be selected from empirically measured traces of the intensity of radiation having different wavelengths that are initially absorbed in and later transmitted through the layer **22** and at least partially reflected by one or more underlayers **24**. This is done by performing a series of experimental process runs and detecting the absorption trace of radiation having different wavelengths in the layer **24** of the substrate **20** as illustrated in the flowchart of Figure 3. In the first step **80**, a thickness measuring machine, such as a model UV1050 available from KLA-TENCOR, Santa Clara, California, was used to accurately determine the thickness of the layer **22** to be deposited upon or etched from the substrate **20**. The final thickness of the layer **22** was also used to estimate the overall operating time of the process.

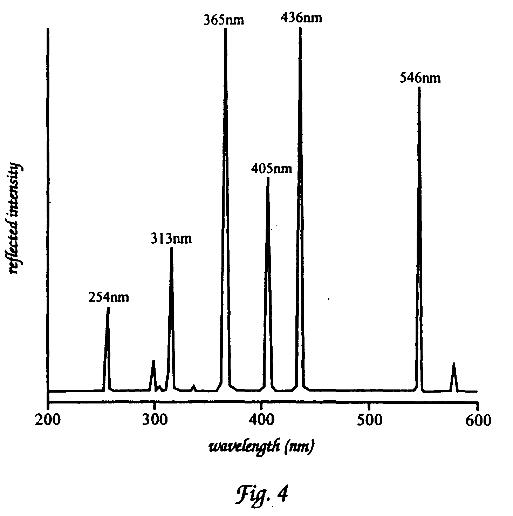

In the next step **82**, a number of substrates were etched in the chamber **28** while different wavelengths of radiation were irradiated on the substrate **20**. The substrates **20** comprised a 500 nm polysilicon layer **22** deposited on a 100 nm silicon dioxide underlayer **24**. The peak intensity of the reflected radiation **64** that occurs approaching the endpoint of the etching of a layer **22** on the substrate **20** was measured by a radiation detector **62**, as provided in step **84**. These process runs were performed using a radiation source **58** providing polychromatic light, such as a Hg-discharge lamp, which was focused on the substrate **20** at a near vertical angle. Figure 4 shows an emission spectra of wavelengths emitted by the Hg lamp and at least partially reflected from the layers **22, 24** on the substrate **20**. A bandpass filter or monochromater is used to select particular wavelengths from the emission spectra. Generally, it is desirable to select radiation that provides a low and constant intensity of reflected radiation **64** at the initial stages of the etching process to reduce errors caused by misinterpretation of change in the reflected intensity, and a high peak intensity at the etching endpoint to provide a large signal to noise ratio which improves detection of the signal. However, an empirical determination of the optimal wavelength may be desirable because the optimal wavelengths of the radiation depend upon the composition and the initial and final thicknesses of the layer **22**.

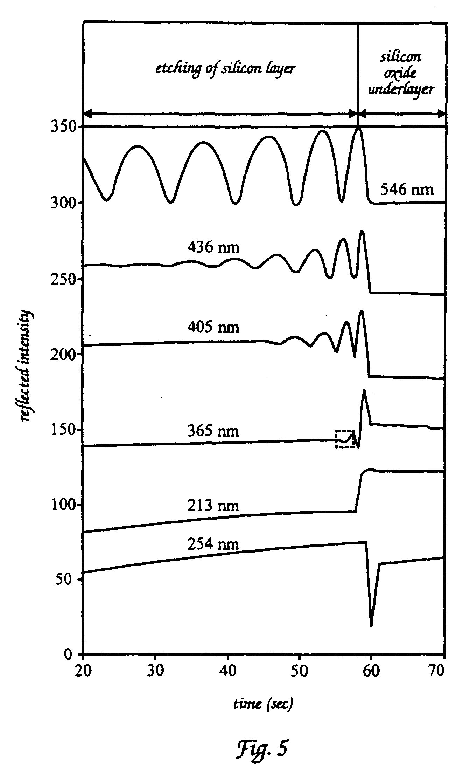

In this example, the wavelengths of 254, 313, 365, 405, 436 and 546 nm, labeled above their corresponding peaks, were selected for further analysis. Thereafter, a trace of the intensity of the reflected radiation **64** for each of the selected wavelengths was measured during processing of the layer **22** on the substrate **20**, as shown in steps **86** and **88**. Figure 5 shows different traces of the change in intensity of reflected radiation occurring during the etching process. An operator searches for a trace in which the intensity of the reflected radiation is substantially constant and absent periodic maxima and minima during most of the etching process, and that suddenly towards the end of the etching process, produces a strong change in reflected intensity. It is seen that for the lower wavelengths, as the thickness of the layer **22** that is being etched becomes smaller, the trace of the reflected radiation **64** changes from a constant level value - where essentially all the component **100** of the incident radiation **60** that is not reflected by the surface **106** of the layer **22** (as illustrated in Figures 1a and 1b) is being absorbed within the layer **22** - to a trace having interference fringes caused by the multiple reflections occurring from the surfaces **106, 108** because the layer **22** is not absorbing the entire component **100** (as illustrated in Figure 1c). For example, the trace of the reflected intensity of radiation having a wavelength of 254 nm is a relatively straight line for **20** to **58** seconds of etching time which indicates almost total absorption of the component **100** into the layer **22**, followed by a single minima occurring at an endpoint of etching of the layer **22**, when the component **100** is reflected by the interface **108** and interferes with the component **104** that is reflected from the surface **106** of the layer **22.** Similarly, the trace of radiation having a wavelength of 313 nm comprises a level portion followed by a single step rise at the endpoint of etching of the layer **22**. The trace at the 365 nm wavelength comprises a straight absorption line with a small dip immediately before the endpoint is reached and allowed by a peak at the endpoint itself. At a wavelength of 405 nm and above, a number of oscillations with maxima and minima peaks occur before reaching the endpoint, indicating that the layer **22** being etched is less absorptive of radiation having these wavelengths and instead begins to transmit the radiation with the resultant occurrence of the multiple fringes, way before the actual endpoint is reached. Similarly, at wavelengths of 436 and 546 nm, a larger number of oscillations occur substantially before the end of the process. The concept of an exponential envelope can be seen where negligible absorption occurs at 546 nm but the magnitude of the interference fringes is rapidly dampened for wavelengths less than 435 nm.

From the traces shown in Figure 5, a wavelength of radiation having a component **100** which is completely absorbed in the layer **22** during the etching process, and which is at least partially transmitted through the layer **22** and reflected from the interface **108** upon approaching the endpoint of the etching process, is selected for endpoint detection. If a suitable wavelength is not obtained, the process is repeated for other wavelengths, as shown in steps **90** and **92**. In the present example, preferably, the radiation for detecting an endpoint for etching of the polysilicon layer **22** on the silicon dioxide underlayer **24**, comprises a wavelength of less than about 600 nm, and more preferably from about 200 nm to about 600 nm.

The selected trace of the reflected intensity of radiation having the preferred wavelength is examined by an operator to determine a desired stopping point for the process being conducted on the substrate **20**, and to locate its associated characteristic waveform feature in the endpoint trace, as provided in step **94**. The desired stopping point can be determined in two ways. First, knowing the etching rate, the time to etch a desired thickness of the layer **22** can be estimated and subtracted from the total etch time to determine the endpoint time that leaves behind a desired remaining thickness of the layer **22**. Second, the trace can be empirically analyzed for identifiable features that provide a desired endpoint time to recognize a feature of the trace as being associated with a remaining thickness of the layer **22**. For example, even for strongly absorbing layers **22**, the few fringes that may appear when the layer **22** is thin are still spaced apart by approximately λ /2n (where λ is the wavelength and n is the real part of the refractive index). Together with an offset thickness if the underlayer **24** is transparent (such as gate oxide), the desired stopping point can be determined by counting features back from the interface between the layer **22** and the underlayer **24**. In either case, a second substrate **20** can be etched and stopped using the endpoint method, without applying a second process step; and the remaining thickness of the layer **22** can be measured. If the remaining thickness is different than desired, the process can be iterated to achieve the desired outcome. This is normally performed as part of "process tuning" to finalize a complete process for endpoint detection.

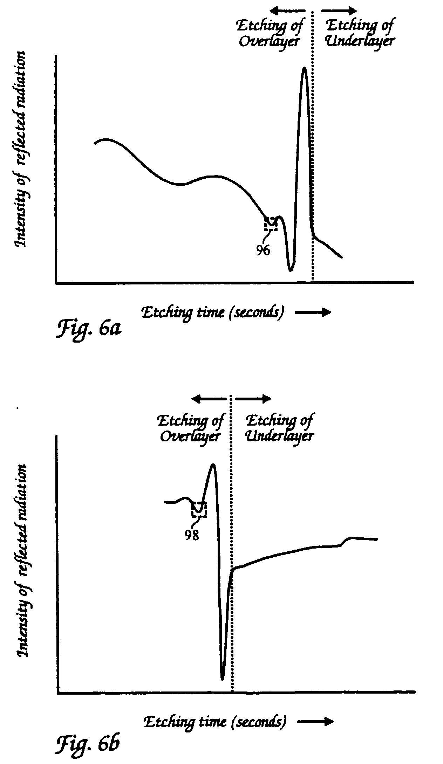

The selected characteristic waveform feature should also have distinct attributes that are easily recognizable even for reflected radiation that is attenuated or has a high signal to noise ratio in the chamber environment. In addition, the characteristic waveform should be sufficiently repeatable, from one substrate **20** to another, to reduce endpoint detection errors in processing of a large batch of substrates **20**. The characteristic waveform features in the endpoint trace can be a peak, valley, slope or combination thereof. For example, Figures 6a and 6b show a portion of a waveform trace or spectra of a reflected radiation **64** having a wavelength of 365 nm that is close to the interface **108** of a polysilicon layer **22** deposited on a silicon oxide layer **24**. The trace is for a substrate **20** with a patterned resist layer over a 5000 Å thickness of polysilicon **30** that overlies a relatively thick 1000 Å layer of silicon dioxide **22**. The selected characteristic waveform comprises a small dip **96** that occurs before the small peak which is immediately in front of the large peak as shown in the inset box. The small dip is easily recognizable by and programmable into the computer program **112** for endpoint detection. In another example, Figure 6b shows the reflected radiation **64** trace obtained for radiation also of the 365 nm wavelength at least partially reflected from a substrate **20** with a patterned resist layer formed over a 2000 Å undoped polysilicon layer **22** on a thin 65 Å silicon dioxide underlayer **24**. The selected characteristic waveform feature comprises a small dip **98** in front of a relatively large peak signal, that is also highly recognizable and repeatable.

### Controller and Computer System

The chamber and endpoint detection system **56** is operated by a chamber controller **110** that executes software of a computer-readable program **112** of a computer system comprising a central processor unit (CPU) **114**, such as for example a 68040 microprocessor, commercially available from Synergy Microsystems, California, or a Pentium Processor commercially available from Intel Corporation, Santa Clara, California, that is coupled to a memory **116** and peripheral computer components. The memory **116** comprises a computer-readable medium having a computer-readable program embodied therein. Preferably, the memory **116** is a hard disk drive **122**, but the memory can also be other kinds of memory, such as random access memory (not shown). In addition to memory **116**, controller **110** can include a floppy disk drive **122** and a card rack. The interface between an operator and the controller **110** can be, for example, via a monitor **118** and a light pen **120**, as shown in Figure 2. The light pen **120** detects light emitted by the monitor **118** with a light sensor in the tip of the light pen **120**. To select a particular screen or function, the operator touches a designated area of a screen on the monitor **118** and pushes the button on the light pen **120**. Typically, the area touched changes color, or a new menu is displayed, confirming communication between the user and the controller **110**. In the preferred embodiment, two monitors **118** and light pens **120** are used, one mounted in a clean room for the operators and the other behind the wall for service technicians. Both monitors **118** simultaneously display the same information, but only one light pen **120** is enabled.

Other computer-readable programs such as those stored on other memory including, for example, a floppy disk or other computer program product inserted in a disk drive **122** or other appropriate drive, may also be used to operate controller **110.** The computer system card rack contains a single-board computer, analog and digital input/output boards, interface boards, and stepper motor controller boards. Various components of the apparatus **26** conform to the Versa Modular European (VME) standard, which defines board, card cage, and connector dimensions and types. The VME standard also defines the bus structure having a 16-bit data bus and **24**-bit address bus.

The computer program **112** generally comprises process control software **124** comprising a set of instructions of program code to operate the chamber **28** and its components, endpoint detection software **126** comprising a set of instructions for operating the endpoint detection system 56, safety systems software, and other control software. The computer-readable program can be written in any conventional computer-readable programming language, such as for example, assembly language, C, C + +, Pascal, or Fortran. Suitable program code is entered into a single file, or multiple files, using a conventional text editor and stored or embodied in the computer-usable medium of the memory **116** of the computer system. If the entered code text is in a high level language, the code is compiled, and the resultant compiler code is then linked with an object code of precompiled library routines. To execute the linked, compiled object code, the user invokes the object code, causing the CPU **114** to read and execute the code to perform the tasks identified in the program.

The selected attribute of the predetermined characteristic feature is programmed into the endpoint detection software **126**, which analyzes an incoming signal trace provided by the radiation detector **62** and determines a process endpoint when a desired set of criteria is reached, such as when an attribute of the detected signal is substantially alike to an attribute of the predetermined characteristic feature. The trace is provided to the controller **110** by an analog to digital converter board (not shown) in the radiation detector **62**. The endpoint detection software **126** operates an endpoint detection controller **130** which sends signals to operate endpoint detection components such as the radiation source **58**, radiation detector **62**, and optionally the lens assembly **66**, filter **76** and other components. The endpoint detection software **126** includes a set of instructions to detect an attribute of a characteristic feature of the signal to determine an endpoint of the process by, for example, detecting a change in intensity or a rate of change of intensity of the reflected radiation **64**. The desired criteria are programmed into the endpoint detection software **126** to identify the endpoint using the preset stored parameters or algorithms.

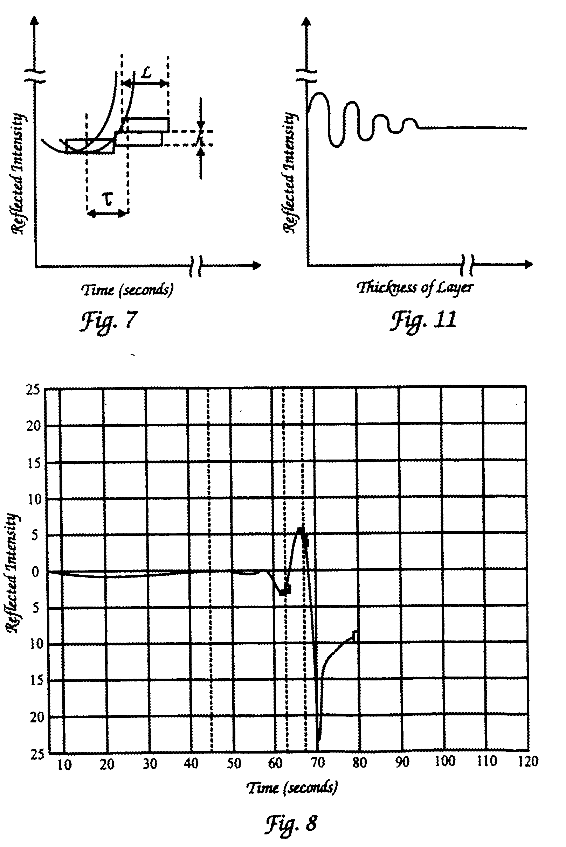

In one method, while a substrate **20** is being processed, the measured trace is continuously analyzed by drawing a box around the end of the trace and back in time, with signal height and time length established in the algorithm, as shown in Figure 7. A set of windows out is programmed to detect a valley in the trace of the reflected intensity. Taller windows could also be used to trigger on the upward slope to detect a later endpoint or set up to trigger on a downward slope to detect an endpoint before a valley in the trace. The first criterion is met when the signal of the trace becomes too steep and exits or moves out of the preprogrammed box ("WINDOW OUT") or when it becomes gradual and enters the box ("WINDOW IN"). Additional boxes or windows are sequentially applied on the moving trace to generate the complete set of criteria to make a determination on whether the change in signal in the trace is the endpoint of the process or is only noise. The direction of entering or exiting a box can also be specified as part of the criteria. A typical set of instructions for setting the programming functions of the box are shown in Table I.

**TABLE I**

| | | | | |
|---|---|---|---|---|
| Algorithm Number (1-62) : 1 | | | | |

| Etch Mode; Endpoint - Depth (Toggle) | ENDPNT | ENDPNT | NONE | NONE |
|---|---|---|---|---|
| Wavelengths [1,2] (2000 - 8000, 0 for NONE) | 3650 | 3650 | | |
| AGC Levels [1,2] (40% - 60%, 0 for NONE) | 50 | NONE | | |
| AGC Time (5.0 - 600.0) | 5.0 | | | |
| Initial Dead Time (0.0 - 999.9) | 40.0 | | | |
| Window Heit (-99.99 - 99.99) | 0.30 | -0.50 | -0.10 | -0.10 |
| Window Time (0.1 - 99.9) | 1.0 | 1.0 | 10.0 | 10.0 |
| Number of Windows Out (1 - 99, 0 for NONE) | 3 | 3 | NONE | NONE |
| Number of Windows In (1 - 99, 0 for NONE) | NONE | NONE | NONE | NONE |
| Derivative Time (0.0 - 19.9) | 0.0 | | | |
| Over Etch (0% - 999%) | 0 | | | |
| Display Start Level (10% - 90%) | 50 | | | |
| Display Gain (1 - 200) | 20 | | | |
| Magnetic Field Period (0.1 - 5.0) | 1.0 | | | |
| Number of Field Periods to Average (0 - 50) | 1 | | | |
| Hi Pass Time Const (0.0 - 600.0) | 0.0 | | | |
| Lo Pass Time Const (0.0 - 600.0) | 0.0 | | | |

In the example provided in Table I, an active endpoint would end a stage of the process being performed on the substrate **20** when the two-column windows-out criteria is established at 68 seconds. In the example shown in Figure 8, an endpoint trace having a two-column criteria comprises windows exiting upward (at 62 sec) and windows exiting downward (at 68 sec) to ensure peak detection. In this example, the peak is associated with a remaining thickness of 220 Å of a polysilicon layer.

The moving-box signal analysis method is useful for discriminating between noise spikes and other spurious signals from the desired change of intensity of the reflected radiation **64** relied upon to determine the process endpoint, and to detect peaks, valleys, or absolute slope change, or a combination of these. The moving-box signal analysis method provides noise-immune slope detection ability and is described in U.S. Patent No. 5,343,412 by Birang et al; and the software for multichannel and multichamber collection of signal traces is described in EP 458324 B1 by Cheng et al; both of which are incorporated herein by reference.

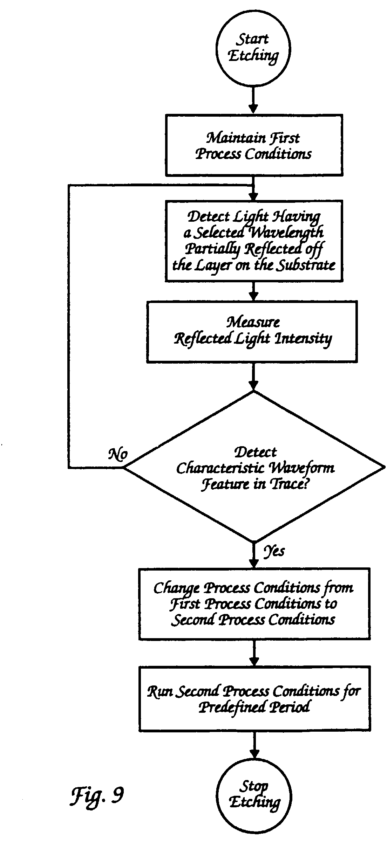

Upon detecting the endpoint of the process, the endpoint detection software **126** on the computer system provides an endpoint signal to the process control software **124** which sends instructions to a process controller **128** to change a process condition in a chamber **28** in which the substrate **20** is being processed. The process controller **128** is adapted to control one or more of the gas delivery system **34**, plasma generator **46**, or throttle valve **44**, to change a process condition in the chamber **28** in relation to an endpoint signal. Figure 9 is a flowchart showing the typical process steps for processing a layer **30** on the substrate **20** and changing process conditions upon detecting an endpoint of the process. In these steps, first process conditions are maintained to process the layer, radiation such as a light beam is focused onto the substrate, and a trace of the reflected intensity of the light beam is measured. When the characteristic feature is detected in the trace of the reflected intensity, the first process conditions are changed to second process conditions, for example, and without limitations, to alter a rate of etching or deposition of the layer **22** on the substrate **20**, to change an etching selectivity ratio, or to add a cleaning gas in a volumetric flow ratio sufficiently high to clean a surface in the process zone **30** of the chamber **28** enclosing the substrate **20**.

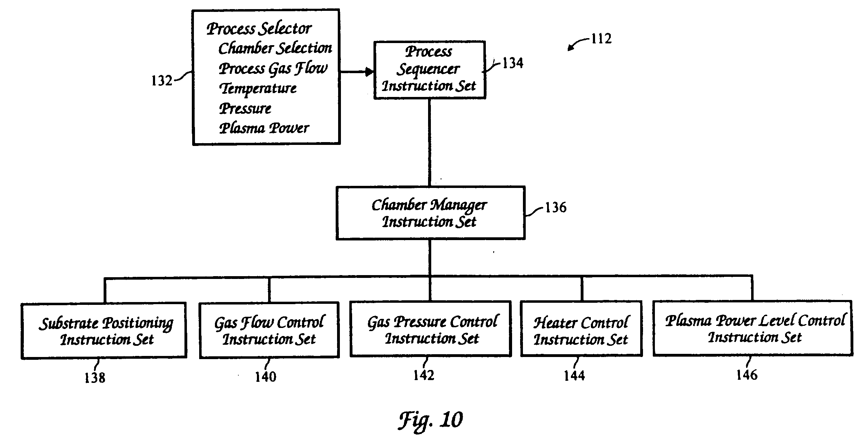

The processes for etching the layer **22** on the substrate **20** and optionally cleaning the chamber **28** are implemented by the process control software **124** and is executed by the process controller **128**. The process control software **124** includes sets of instructions that dictate the timing, gas compositions, gas flow rates, chamber pressure, chamber temperature, RF power levels, support position, heater temperature, and other parameters of a particular process. Figure 10 is an illustrative block diagram of the hierarchical control structure of the process control software **124**, according to a specific embodiment. Using a light pen interface, a user enters a process set number and process chamber number into a process selector instruction set **132** in response to menus or screens displayed on the CRT terminal. The process sets are predetermined groups of process parameters necessary to carry out specified processes, and which are identified by predefined set numbers. Process selector instruction set **132** identifies (i) a desired process chamber **28**, and (ii) the desired set of process parameters needed to operate the process chamber for performing the desired process. The process parameters for performing a specific process relate to process conditions, without limitations, such as for example, gas composition, gas flow rates, temperature, pressure, plasma conditions such as RF power levels (and in addition, microwave generator power levels for embodiments equipped with remote microwave plasma systems), cooling gas pressure and chamber wall temperature. Process selector instruction set **132** controls what type of process (etching, deposition, wafer cleaning, chamber cleaning, chamber gettering, reflowing) is performed at a certain time in chamber. In some embodiments, there may be more than one process selector instruction set **132**. The process parameters are provided to the user in the form of a recipe and may be entered utilizing the light pen and monitor interface.

A process sequencer instruction set **134** comprises program code for accepting the identified process chamber **28** and set of process parameters from the process selector instruction set **132**, and for controlling operation of the various process chambers. Multiple users can enter process set numbers and process chamber numbers or a single user can enter multiple process set numbers and process chamber numbers, so the sequencer instruction set **134** operates to schedule the selected processes in the desired sequence. Preferably the sequencer instruction set **134** includes program code to perform the steps of (i) monitoring the operation of the process chambers **28** to determine if the chambers are being used, (ii) determining what processes are being carried out in the chambers being used, and (iii) executing the desired process based on availability of a process chamber **28** and the type of process to be carried out. Conventional methods of monitoring the process chambers **28** can be used, such as polling. When scheduling which process is to be executed, sequencer instruction set **134** can be designed to take into consideration the present condition of the process chamber **28** being used in comparison with the desired process conditions for a selected process, or the "age" of each particular user-entered request, or any other relevant factor a system programmer desires to include for determining scheduling priorities.

Once the sequencer instruction set **134** determines which process chamber **28** and process set combination is going to be executed next, the sequencer instruction set **134** initiates execution of the process set by passing the particular process set parameters to a chamber manager instruction set **136** that controls multiple processing tasks in a process chamber **28** according to the process set determined by the sequencer instruction set **134**. For example, the chamber manager instruction set **136** comprises program code for controlling etch or deposition operations in the process chamber **28**. Chamber manager instruction set **136** also controls execution of various chamber component instruction sets that control operation of the chamber components necessary to carry out the selected process set. Examples of chamber component instruction sets are substrate positioning instruction set, gas flow control instruction set **140**, gas pressure control instruction set **142**, optional heater control instruction set **144** for chambers equipped with a heater in the support, and plasma control instruction set **146**. Depending on the specific configuration of the chamber **28,** some embodiments include all of the above instruction sets or instruction set, while other embodiments may include only some of the instruction sets. Those having ordinary skill in the art would readily recognize that other chamber control instruction sets can be included depending on what processes are to be performed in the process chamber **28**.

In operation, the chamber manager instruction set **136** selectively schedules or calls the process component instruction sets in accordance with the particular process set being executed. The chamber manager instruction set **136** schedules the process component instruction sets much like the sequencer instruction set schedules which process chamber **28** and process set are to be executed next. Typically, chamber manager instruction set **136** includes steps of monitoring the various chamber components, determining which components need to be operated based on the process parameters for the process set to be executed, and initiating execution of a chamber component instruction set responsive to the monitoring and determining steps.

Operation of chamber component instruction sets will now be described. The substrate positioning instruction set **138** comprises program code for controlling chamber components that are used to load the substrate **20** onto the support **32** and optionally, to lift the substrate **20** to a desired height in the chamber **28** to control the spacing between the substrate **20** and the gas outlets **38** of the gas delivery system **34**.

The process gas control instruction set **140** has program code for controlling the flow rates of different constituents of the process gas. The process gas control instruction set **140** controls the open/close position of the safety shut-off valves, and also ramps up/down the mass flow controllers to obtain the desired gas flow rate. The process gas control instruction set **140** is invoked by the chamber manager instruction set **136**, as are all chamber component instruction sets, and receives process parameters related to the desired gas flow rates from the chamber manager **136**. Typically, the process gas control instruction set **140** operates by opening the gas supply, and repeatedly (i) reading the necessary mass flow controllers, (ii) comparing the readings to the desired flow rates received from the chamber manager instruction set **136**, and (iii) adjusting the flow rates of the gas supply lines as necessary. Furthermore, process gas control instruction set **140** includes steps for monitoring the gas flow rates for unsafe rates and activating the safety shut-off valves when an unsafe condition is detected. Process gas control instruction set **140** also controls the gas composition and flow rates for clean gases as well as for etching of deposition gases, depending on the desired process (etching, clean or deposition or other) that is selected. Alternative embodiments could have more than one process gas control instruction set **140**, each instruction set controlling a specific type of process or specific set of gas flow controllers.

In some processes, an inert gas such as nitrogen or argon is flowed into chamber **28** to stabilize the pressure in the chamber before reactive process gases are introduced. For these processes, the process gas control instruction set **140** is programmed to include steps for flowing the inert gas into chamber **28** for an amount of time necessary to stabilize the pressure in the chamber, and then the steps described above would be carried out. Additionally, when a process gas is to be vaporized from a liquid precursor, for example in the deposition of TEOS-derived glass, process gas control instruction set **140** is written to include steps for bubbling a delivery gas, such as helium, through the liquid precursor in a bubbler assembly, or for introducing a carrier gas, such as helium, to a liquid injection system. When a bubbler is used for this type of process, the process gas control instruction set **140** regulates the flow of the delivery gas, the pressure in the bubbler, and the bubbler temperature in order to obtain the desired process gas flow rates. As discussed above, the desired process gas flow rates are transferred to the process gas control instruction set **140** as process parameters. Furthermore, the process gas control instruction set **140** includes steps for obtaining the necessary delivery gas flow rate, bubbler pressure, and bubbler temperature for the desired process gas flow rate by accessing a stored table containing the necessary values for a given process gas flow rate. Once the necessary values are obtained, the delivery gas flow rate, bubbler pressure, and bubbler temperature are monitored, compared with the necessary values, and adjusted accordingly.

The pressure control instruction set **142** comprises program code for controlling the pressure in the chamber **28** by regulating the aperture size of the throttle valve **44** in the exhaust system **42** of the chamber. The aperture size of the throttle valve **44** is set to control the chamber pressure at a desired level in relation to the total process gas flow, the size of the chamber **28**, and the pumping set-point pressure for the exhaust system **42**. When the pressure control instruction set **142** is invoked, the desired or target pressure level is received as a parameter from the chamber manager instruction set **136**. The pressure control instruction set **142** measures the pressure in the chamber **28** by reading one or more conventional pressure manometers connected to the chamber **28**, compares the measure value(s) with the target pressure, obtains PID (proportional, integral, and differential) values corresponding to the target pressure from a stored pressure table, and adjusts the throttle valve **44** according to the PID values obtained from the pressure table. Alternatively, the pressure control instruction set **142** can be written to open or close the throttle valve **44** to a particular aperture size to regulate the pumping capacity in chamber **28** to the desired level.

Optionally, the heater control instruction set **144** comprises program ode for controlling the temperature of an optional heater element (not shown) used to resistively heat the support **32** and substrate **20**. The heater control instruction set **144** is also invoked by the chamber manager instruction set **136** and receives a target, set-point, or temperature parameter. The heater control instruction set **144** measures the temperature by measuring voltage output of a thermocouple located in the support, comparing the measured temperature with the set-point temperature, and increasing or decreasing current applied to the heating unit to obtain the set-point temperature. The temperature is obtained from the measured voltage by looking up the corresponding temperature in a stored conversion table or by calculating the temperature using a fourth-order polynomial. When an embedded loop is used to heat support, the heater control instruction set **144** gradually controls a ramp up/down of current applied to the loop. Additionally, a built-in, fail-safe mode can be included to detect process safety compliance and to shut down operation of the heating unit if the process chamber **28** is not properly set up.

The plasma control instruction set **146** comprises program code for setting low and high-frequency RF power levels applied to the process electrodes **50**, **52** in the chamber **28.** Like the previously described chamber component instruction sets, the plasma control instruction set **146** is invoked by the chamber manager instruction set **136**. For embodiments including remote plasma generator **46**, the plasma control instruction set **146** would also include program code for controlling a remote plasma generator (not shown).

### Calculated Endpoint Absorption Trace

In another version of the present invention, the trace of the reflected radiation **64** is mathematically modeled or calculated and stored as a reference trace for algorithm determination. The trace is calculated ahead of time using an optical absorption model and knowing values for other parameters of the layer **22**, e.g., its composition, refractive index, extinction coefficient, thickness, and other optical constants; the process etch rate and etching selectivity; and the amount of overlying resist area. In this version, the endpoint detection software **126** of the computer program **112** is programmed with code instructions to determine the net reflected amplitude of the radiation **64** or predict a change in the intensity of the reflected radiation that occurs as the layer **22** is completing processing.

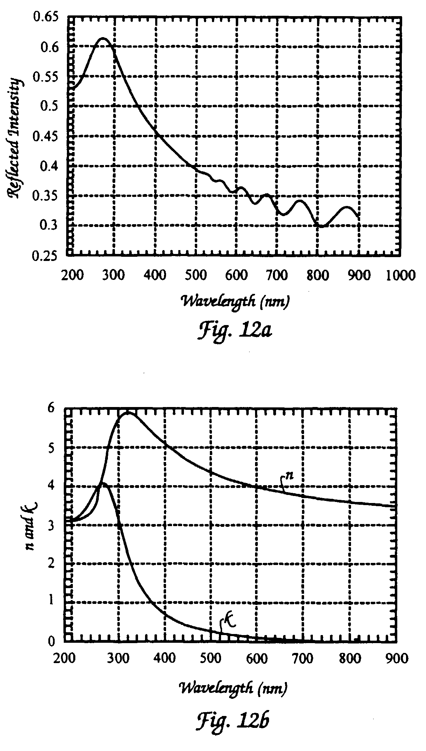

For example, Figure 11 shows a mathematically modeled trace of the intensity of reflected radiation **64** from an absorbing layer **22** on a substrate **20** for increasing thicknesses of the layer **22**. Such an increasing thickness of the layer **22** occurs during deposition of the layer **22** in processes such as, and without limitation, CVD, PVD and oxidation processes. In such deposition processes, the endpoint detection method is used to detect completion of a process of depositing the layer **22** on the substrate **20** when the thickness of the layer **22** reaches a predetermined thickness. In the deposition processes, instead of looking for the appearance of a characteristic feature or some other attribute in the trace of the intensity of the reflected radiation **64**, it is the disappearance of a characteristic feature or attribute in the trace of the intensity of the reflected radiation **64** that is indicative of the approaching endpoint of the process. This sequence of events is simply a reverse sequence as that shown for example in Figures 1b and 1c. Initially, the radiation **60** that is incident upon the substrate **20** is reflected by the surfaces **106, 108** of the layer **22** being deposited on the substrate **20**, because the layer **22** only has a thickness *d*_{*3*} that is sufficiently small to be substantially non-absorbing or absorbing only to a small degree, as illustrated schematically in Figure 1c. As the thickness of the layer **22** begins to grow during the deposition process, the incident radiation is continued to be partially reflected from the surface **106** of the layer **22** and partially reflected from the underlying interface **108**, and the two reflected components **104,109** constructively or destructively interfere due to their difference in pathlengths to provide a series of interference fringes as shown in Figure 11. However, upon approaching the endpoint of the process, the thickness *d*_{*2*} of the layer **22** being deposited now approaches a thickness level at which the component **100** of the incident radiation **60** is substantially absorbed in a predetermined pathlength **102** of the thickness of the deposited layer **22**, which results in the disappearance of the interference fringes at this time. One or more of the disappearance effect, a predetermined time period before or after the disappearance of the fringes, or an appearance of a characteristic feature or attribute at a predetermined time period, is used to call the endpoint of the deposition process. As a rule of thumb, the thickness of the layer at which the interference fringes of the reflected radiation begin to appear or disappear is given by: d (0.37λ)/*k*, where *k* is the extinction coefficient of the layer **22** being deposited on the substrate **20**. A modeled trace can be used to determine a suitable characteristic feature for endpoint detection, and as in the etching processes, the thickness and material properties of underlayers **24** also affect the shape and other properties of the trace of the reflected intensity.

For the processing of more complex systems comprising multiple layers having different compositions, such as a multicomponent polycide layer **22** comprising tungsten silicide deposited over polysilicon, the reflected trace will exhibit the same general behavior, but can be more precisely modeled by a matrix in which each component of the multicomponent layer **22** is represented by a 2 x 2 mathematical matrix that is used to calculate the total absorption/reflectivity of the layer **22**. Thus, the computer program **112** can also comprise a set of instructions comprising program code to calculate a matrix comprising an array of values representing the total absorption or reflectivity obtained in each component of the layer **22** on the substrate **20**. Lateral differences in the multicomponent layer **22** that arise from the features formed in the layer **22** can also be accounted for by summing the complex reflected amplitudes vectorially with phase from each multicomponent layer **22** to determine the total reflected intensity from the layer **22**. Accordingly, the program code comprises a set of instructions to determine lateral differences in the multicomponent layer **22** arising from features formed in the layer **22** by summing the complex reflected amplitudes of all the components of the layer **22** to determine the total reflected intensity from the multicomponent layer **22**. Alternatively, a recursive method can be used to model the trace of reflected radiation from such layers **22**.

These equations and attributes are programmed into the endpoint detection software **126** of the computer program **112** to mathematically predict a change in intensity of the reflected radiation **64** as the layer is being processed, and to identify a suitable endpoint signal or characteristic feature that occurs during the process being performed on the substrate **20**. In general, the endpoint detection software **126** of the computer program **112** comprises program code instructions for (i) modeling of a trace of the intensity of reflected radiation **64** as the substrate **20** undergoes processing, (ii) optionally, selecting a characteristic feature from the modeled trace of the radiation (or a user can select the characteristic feature), (iii) storing the modeled trace and/or the characteristic feature, and (iv) detecting a portion of an incoming radiation signal from the radiation detector **62** and analyzing the measured signal relative to the attributes of the stored trace or characteristic feature, and when they are sufficiently alike in some attribute, calling an endpoint of the process being performed on the substrate **20**.

For example, Figure 12a is a calculated trace of the change in reflected intensity of radiation directed on a substrate **20** that comprises a small grained polysilicon layer **22** over a silicon dioxide layer **24** on silicon (not shown), for increasing wavelengths of radiation directed onto the substrate **20**. The polysilicon layer **22** had a thickness of 6000 Å and the underlying silicon dioxide layer **165** a thickness of 35 Å. The curve is calculated to fit experimentally determined values of n (real part) and *k* (imaginary part) of the complex refractive index for increasing wavelengths of the reflected radiation, as shown in Figure 12b. It should be noted that the extinction coefficient *k* become sufficiently large at low wavelengths to suppress optical interference from the back of the layer **22** and the underlayer **24**. The point at which the interference fringes become small, for example at 1 % of the total reflected intensity, is at a thickness of d ≅ (0.37λ)/*k*. Thus, the appearance or disappearance of a contribution to the total reflected intensity of radiation from below the surface of the layer **22** is clearly related to the wavelength and the extinction coefficient. Since *k* is a material parameter of the layer **24**, a suitable wavelength of the radiation can be selected to yield a desired thickness at which the total change in intensity of the reflected radiation **64** becomes apparent in an etching or deposition process, and can be used to control the process. The onset of the interference fringes occurs at different thicknesses of the residual polysilicon layer **22** because the extinction coefficient *k* and hence the optical absorption varies for different wavelengths. For the example shown, a wavelength can be chosen to provide -- in the case of etching a substrate **20**- an onset of an interference fringe or other recognizable feature that occurs at any remaining thickness of the etched polysilicon layer **22**.

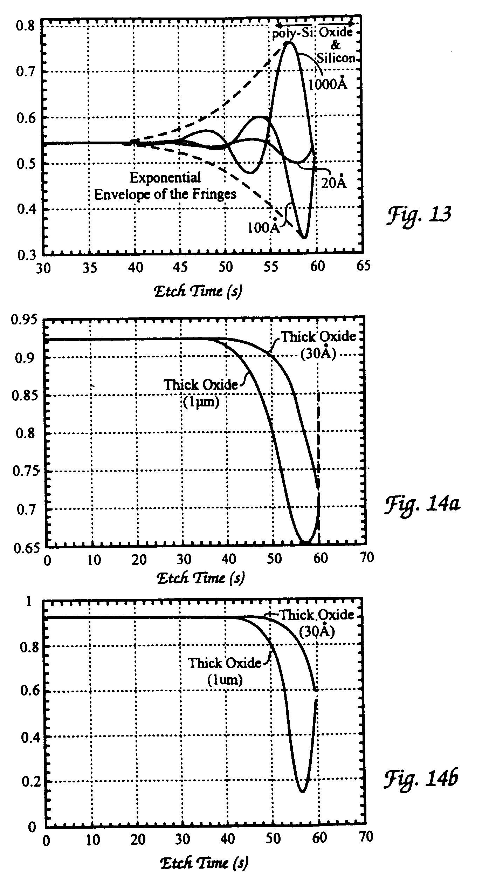

In another example, Figure 13 is a calculated trace of the change in intensity of reflected radiation **64** from a substrate **20** comprising a polysilicon layer **22** having an initial thickness of 2000 Å over an underlying silicon dioxide layer **24** having thicknesses of 20, 100, and 1000 Å, respectively, as a function of etch processing time. In the simulation, the etch rate of the polysilicon layer **22** was set at 2000 Å/min. Note that the onset of the interference fringes is not only dependent upon the thickness of the residual polysilicon layer **22** but also dependent upon the thickness of the underlying layer **22**. Thus, while all the curves reach the same etching point at the same time, for example, reach the interface between the layer **24** and the layer **22** at about 60 seconds, each curve has a different onset time for the appearance of an interference fringe, as well as different shapes of interference fringes. This example demonstrates the desirability of empirically or mathematically determining a trace of the reflected intensity for a particular substrate **20**, and thereafter select a suitable characteristic feature or change in the trace of the reflected intensity to determine the process endpoint.

In yet another example, Figure 14a is a calculated trace of the intensity of radiation having a preselected wavelength of 2537 angstroms, that is at least partially reflected from a substrate **20** comprising an aluminum layer **22** having a thickness of 1000 Å that is etched at an etch rate of 1000 Å/min, and that lies over an oxide layer **24** on silicon (not shown). The trace is calculated as the substrate **20** is being etched and for two different thicknesses of underlying oxide layer **24** of 30 Å (thinner layer) and 1 micron (thicker layer). Note that at an 80% level of the reflected intensity -- arbitrarily selected as a signal change that could be indicative of an endpoint of the process - the thickness of the residual unetched aluminum layer **22** is about 170 Å on the substrate **20** having the thicker oxide layer **24** and only about 55 Å on the substrate **20** having the thinner oxide layer **24**. The 80% level could be used as a predetermined quantitative level of change in intensity of the reflected radiation **64** for detecting the endpoint of the process, however, it is necessary to determine the trace of the reflected radiation **64** for the particular features or characteristics of the substrate **20** being processed, otherwise, the endpoint would be called for an erroneous residual thickness of etched material. In yet another example, Figure 14b shows a calculated trace of the change in intensity of radiation having a preselected wavelength of 3650 angstroms, that is at least partially reflected from the same substrate **20**. Again, it is seen that at the 80% level of the reflected intensity, the thickness of the residual unetched aluminum layer **22** is about 150 Å on the substrate **20** having the thicker oxide layer **24** and about 65 Å on the substrate **20** having the thinner oxide layer **24**, indicative of the effect of the properties of the underlying layer **24**.

The endpoint detection method of the present invention significantly improved substrate yields and was especially useful in the etching of polysilicon layers overlying thin gate oxide underlayers having thicknesses as low as 25 to 65 A - more than 4 times thinner than prior art gate oxide layers. By stopping the etching process before the thin gate oxide layer is etched through or otherwise damaged, the endpoint method provided higher yields of integrated circuits from a substrate.

### Example 1: Cleaning and Etching Process

In this example, the chamber **28** used for deposition or etching is cleaned to remove residue deposits and contaminants that are deposited on walls, components, and other surfaces in the chamber; otherwise, the deposits can flake off and contaminate the substrate **20**. In conventional etching processes, the chamber **28** is opened to the atmosphere after etching of 100 to 300 wafers and cleaned in a "wet-cleaning" process, in which an operator uses an acid or solvent to scrub-off accumulated etch residue. After cleaning, the chamber **28** is pumped down for 2 to 3 hours to outgas volatile species, and thereafter, a number of etching runs are performed on dummy wafers until consistent etching results are obtained. The downtime of the etching chamber **28** during the wet cleaning process substantially increases the cost per substrate **20** and capitalization costs. Also, because the wet cleaning process is performed manually, the cleanliness of the chamber surfaces often varies from one cleaning session to another. Thus it is desirable to reduce or eliminate the deposits formed on chamber surfaces during processing of a substrate **20** to reduce use or eliminate wet cleaning steps.

Thus, another aspect of the present invention, comprises a cleaning process performed along with the etching process. In a preferred version, a first layer **22** on a substrate **20** is etched in a first stage of the etching process, by a process gas comprising a composition of etchant gas that provides a high etching rate and a chamber cleaning gas that cleans the etchant residue formed on the walls of the chamber **28.** An etching endpoint is detected immediately prior to etching through the first layer **22**, and the composition of the process gas is changed in a second stage of the process to remove the cleaning gas to etch the remaining portion of the first layer without damaging the underlying second layer **22**. The cleaning gas in the first stage of the process cleans the etching chamber **28** without requiring stopping etching in between processing of batches of substrates **20** to perform wet cleaning processes.

Instead of in the first stage, the cleaning gas can also be added to the process gas in any etching stage that is used to etch through a particular layer **22** on the substrate **20**. For example, multiple stage etching processes can be used to etch stacked layers of different materials on the substrate **20**. In such processes, the cleaning gas is introduced in at least one of the stages to remove the etchant residue deposited on the chamber surfaces during all of the preceding or succeeding stages. The multiple stage process is useful for etching polycide structures that comprise multiple layers **22** of tungsten silicide and polysilicon layers or for etching silicon nitride layers or silicon dioxide layers on silicon wafers. Although the multiple stage process is illustrated in the context of etching such layers, it should be understood that the process can be used to etch other layers such as metal layers. Thus, the present process should not be limited to the examples and illustrative methods provided herein.

In the cleaning stage, cleaning gas is added to the etchant gas so that the etchant residue formed on chamber surfaces during etching is substantially entirely removed by the end of the etching process. In a preferred embodiment, the etchant gas comprises one or more of Cl₂, N₂, O₂, HBr, or He-O₂; and the cleaning gas comprises inorganic nonhydrocarbon-containing fluorinated gas such as one or more of NF₃, CF₄, or SF₆. Preferably, the volumetric flow ratio of cleaning gas to etchant gas is selected to remove substantially the entire etchant residue from the chamber surfaces upon completion of the etching process. More preferably, the volumetric flow ratio of cleaning gas to etchant gas is selected to remove substantially all the etchant residue formed during processing of at least 2000 substrates **20** in the chamber **28**, without performing a separate cleaning step for cleaning the chamber. A suitable volumetric flow ratio of cleaning gas to etchant gas is from about 1:20 to about 1:1, and more preferably from about 1:10 to about 2:3, and most preferably about 2:3. It has been discovered that at these volumetric flow ratios substantially all the etchant residue on the chamber surfaces are removed without eroding the chamber surfaces. In addition, it has been unexpectedly discovered that the chamber surfaces are cleaned and conditioned by the etchant and cleaning gas combination step, without requiring a separate chamber **28** conditioning or seasoning step.

In the etching of silicon-containing layers **22**, the addition of fluorinated cleaning gas to the etchant gas composition, makes the resultant process gas highly reactive to the silicon-containing layers and provides a high etch rate and a low etching selectivity ratio for etching an overlying polysilicon layer relative to an underlaying silicon dioxide layer. Typically, the addition of cleaning gas drops the etching selectivity ratio down to 4:1 to 6:1. In contrast, the etching selectivity ratio obtained with conventional etchant gas compositions is from 10:1 to 12:1. This causes the cleaning gas plasma to etch or damage the underlayer **24** when the underlayer is exposed to the plasma. This is even more of a problem when the underlayer **24** is very thin, on the order of a few layers of atoms, and is very quickly damaged or etched through.

In the etching process, the substrate **20** is first etched by a first process gas comprising a mixture of etchant gas and cleaning gas. The etchant gas comprises 120 sccm HBr, 30 sccm Cl₂, and 10 sccm He-O₂ (containing 30% O₂). The cleaning gas composition comprises CF₄ added to the etchant gas in a volumetric flow rate of about 25% of the total flow rate of cleaning gas, which is about 40 sccm. The source power level of the inductor antenna is maintained at about 500 watts and the RF bias power level of the process electrodes at about 100 W. The gas pressure is about 4 mTorr and the temperature of the support at about 50°C. The cleaning gas throughly cleaned all the etchant residue deposits off the chamber walls during the etching process so that a separate wet cleaning step was not needed. However, it was determined that the addition of CF₄ gas reduced the etching selectivity ratio for etching polysilicon relative to the underlying silicon dioxide to an etching selectivity ratio of about 5:1. The relatively low etching selectivity ratio would result in rapid deterioration of the underlayer **24** if the etching process was not changed prior to completion of etching of the underlayer.

During the first stage of the etching process, the endpoint detection system **56** was programmed to detect an endpoint for etching the layer **22** on the substrate **20**, when etching had proceeded to near completion, i.e., with about 30 nm of polysilicon layer remaining on the substrate. When the selected characteristic waveform feature was detected by the computer system, the first process conditions were changed to second process conditions to reduce the etching rate and increase or maximize the etching selectivity ratio for etching the polysilicon layer **22** relative to the underlying silicon dioxide layer. The second process conditions used a second process gas comprising 120 sccm HBr and 10 sccm He-O₂ (without any Cl₂ or CF₄ added to the process gas) to etch the remaining 300 Å portion of the polysilicon layer **22**. The pressure in the chamber **28** was maintained at a much higher pressure of **55** mTorr, the inductor source power level at 900 watts, and the RF bias power level at 70 watts, to provide a higher source to bias power ratio of about **12**. The second process gas composition, being absent CF₄ cleaning gas, provided an etching selectivity ratio for etching polysilicon relative to the underlying silicon dioxide of about 12:1, which is more than two times higher than the etching selectivity ratio obtained from the first process gas comprising both cleaning and etchant gas. This significantly reduced damage of the underlayer 24 on the substrate 20.

### Example 2:

In another example, a substrate **20** comprising polycrystalline silicon is etched in the first stage using a plasma of a first process gas comprising Cl₂, N₂, and CF₄, and optionally O₂. Preferably, the volumetric flow ratio of Cl₂, N2, and CF₄ is selected to remove substantially all the etchant residue generated by etching at least 2000 substrates **20** in the chamber **28**, without performing a separate cleaning step for cleaning the chamber. The ratio of the volumetric flow ratio of CF₄:(Cl₂ + N₂) is more preferably from about 1:20 to about 1:1. Thereafter, in the second stage of the process, the flow of cleaning gas is terminated, and the substrate **20** is processed with an etchant gas that is absent cleaning gas. The CF₄ gas can also be substituted with SF₆ or NF₃.

### Example 3:

A multistage process can also be used to etch different layers **22** on the substrate **20**, and the cleaning gas is introduced in at least one of the stages to remove the etchant residue deposited on the chamber surfaces. The substrate comprises a multilayer polycide structure comprising tungsten silicide over polysilicon. The tungsten silicide layer **22** is etched using a first process gas comprising chlorinecontaining gases, for example, a mixture of chlorine and nitrogen, and optionally oxygen. Preferably, the volumetric flow ratio of chlorine to nitrogen is about 1:3 to about 1:1, and more preferably about 2:3. The pressure in the chamber **28** is maintained at 1 to 10 mTorr, the inductor coil source power level at 200 to 800 Watts, and the RF bias power level of the process electrodes at 20 to 120 Watts.

In the second etching stage, a second process gas is introduced into the chamber **28** and a plasma is formed to etch a second layer **22**, such as a polysilicon layer, below the tungsten silicide layer, after the tungsten silicide layer has been completely etched. The polysilicon layer **22** can be etched in more than one etching process step, with the etchant gas composition being changed during each etching step. Suitable second process gas compositions comprise Cl₂ in a flow rate of from 20 to 120 sccm, HBr at about 80 to 240 sccm, and He-O₂ at about 2 to 10 sccm. The chamber pressure is from about 25 to 200 mTorr. The power level of the source current applied to the inductor antenna **48** is from about 200 to 800 Watts, and the bias RF power level of the voltage applied to the process electrodes **50, 52** is from about 20 to 120 Watts.

In one or more of the first and second stages, a cleaning gas is added to the etchant gas in a volumetric ratio selected so that the etchant residue formed in any one of the stages is substantially entirely removed during the etching process. The etchant residue formed in the first and second stages typically comprises polymeric organic compounds containing halogen, carbon, hydrogen, and oxygen. When silicon-containing layers **22** are being etched, the etchant residue comprises predominantly silicon dioxide compounds formed during etching of both the tungsten silicide and polysilicon layers on the substrate **20**. However, the composition of etchant residue can vary from the first to the second layer **22**, the first etchant residue composed more of W and Si species and the second etchant residue composed more of Si and O species. Thus the cleaning gas is added to the process gas in the first or second stage, in a volumetric ratio suitable for removing the first etchant residue formed in the first etching stage in which the tungsten silicide layer **22** is etched, as well as the second etchant residue formed during the second etching stage in which the polysilicon layer is etched. A suitable volumetric flow ratio of cleaning gas to etchant gas is from about 1:10 to about 2:3. For example, to a flow rate of first etchant gas of about 80 sccm Cl₂ and 40 sccm N₂, a cleaning gas comprising CF₄ at a flow rate of 80 sccm was added to provide a volumetric ratio of cleaning gas to first etchant gas of about 2:3.

The cleaning process removes substantially all the etchant residue formed during processing of over 2000 substrates **20**. In one experiment, over 3000 substrates **20** of silicon wafers having an underlayer **24** of 1000 Å of SiO₂, covered by a polycide layer **22** comprising 3000 Å of polysilicon and 3000 Å of WSiₓ, were sequentially etched in the etching chamber **28**, and the properties of the etched features, etching rates, and etching selectivity ratios measured for selected wafers. The tungsten silicide layer **22** was etched using a first process gas comprising etchant gas of 80 sccm Cl₂ and 40 sccm N₂, and cleaning gas of 80 sccm CF₄, which provides a volumetric flow ratio of cleaning gas to etchant gas of about 2:3. The pressure in the chamber **28** was maintained at 4 mTorr, the source power level was set at 600 Watts and the R.F. bias power level at 60 watts.

The etching and cleaning process was found to uniformly etch substrates **20** while simultaneously removing etchant residues deposited on the chamber **28** during the etching process, irrespective of the thickness or chemical stoichiometry of the etchant residue layers **22**. Prior art etching processes required cleaning and conditioning of the chamber **28** after processing of only 200 to 300 wafers, because of the variation in etching rates and etching selectivity ratio and the higher particle contamination levels that resulted from etchant residue deposits on the chamber surfaces, after processing this number of wafers. Also, prior art cleaning processes, particularly those performed by an operator, often fail to uniformly clean and remove the etchant residue deposits formed on chamber surfaces, and such buildup of etchant deposits resulted in flaking off and contamination of the substrate **20**.

In contrast, the process of the present invention removes etchant residues formed across substantially all of the chamber surfaces to reduce contamination and increase substrate yields. The cleaning gas also results in much less erosive damage to the chamber **28** compared to conventional in-situ plasma cleaning steps because of the reduced energy levels of the plasma in the chamber. This was difficult to accomplish in prior art processes because the high powered plasmas used to remove the residue deposits also resulted in erosion damage of chamber surfaces and components. The cost of operating the chamber **28** and the cost per substrate **20** are significantly reduced by reducing the need to replace chamber components. Furthermore, the cleaning gas can be used to efficiently clean a chamber **28** in-situ during etching of substrates **20**, rather than stopping of processing to wet clean the chamber walls and components, thereby increasing process throughput and further reducing costs per substrate. The etching and cleaning process is expected to increase chamber lifetimes by a factor of at least 2, and also increase substrate yields by reducing the deposition of flaked-off etchant byproducts onto the substrate **20**.

The present invention is described with reference to certain preferred versions thereof, however, other versions are possible. For example, the endpoint detection process can be used for detecting endpoints in other processes and in other chambers as would be apparent to one of ordinary skill, including without limitation, sputtering chambers, ion implantation chambers and other deposition chambers. Therefore, the spirit and scope of the appended claims should not be limited to the description of the preferred versions contained herein.

## Claims

1. A method of etching a layer on a substrate in a chamber, the method comprising the steps of:
(a) placing the substrate in the chamber;
(b) providing in the chamber, a process gas comprising etchant gas and cleaning gas, and maintaining process conditions to etch the layer on the substrate and simultaneously clean a surface of the chamber; and
(c) prior to etching through the layer, changing the composition of the process gas to remove the cleaning gas.

2. A method according to claim 1, wherein the etchant gas comprises one or more of CL₂, Hbr, N₂, O₂, or He-O₂.

3. A method according to claim 1, wherein the cleaning gas comprises one or more of NF₃, CF₄, or SF₆.

4. A method according to claim 1, wherein the volumetric flow ratio of cleaning gas to etchant gas is from about 1:20 to about 1:1.
